# EUROPÄISCHE PATENTSCHRIFT

(11) **EP 2 852 791 B1**
(45) Veröffentlichungstag und Bekanntmachung des Hinweises auf die Patenterteilung: **29.11.2017**
(21) Anmeldenummer: 13724795.3
(22) Anmeldetag: 17.05.2013
(51) Int. Cl.: F21V 23/00, F21V 23/06, H01R 12/72, F21K 9/23, F21K 9/27, F21Y 101/00, F21Y 115/10, H01R 9/18, H01R 13/11, H05K 1/11

(54) **LEUCHTVORRICHTUNG MIT TREIBER**
LIGHTING APPARATUS HAVING A DRIVER
DISPOSITIF D'ÉCLAIRAGE À PILOTE

(30) Priorität: 22.05.2012 DE 102012208587
(43) Veröffentlichungstag der Anmeldung: 01.04.2015
(73) Patentinhaber: LEDVANCE GmbH, 85748 Garching (DE)
(72) Erfinder: FUERSICH, Josef, 85131 Pollenfeld (DE); KRIEGLMEYER, Christoph, 85122 Hitzhofen / Hofstetten (DE); STARK, Roland, 91809 Wellheim (DE)
(74) Vertreter: Nordmeyer, Philipp Werner
(86) Internationale Anmeldenummer: PCT/EP2013/060306
(87) Internationale Veröffentlichungsnummer: WO 2013/174765

(56) Entgegenhaltungen:
- WO-A1-01/59886
- US-A1- 2010 033 972
- US-A1- 2011 028 015

## Beschreibung

Die Erfindung betrifft eine Leuchtvorrichtung, aufweisend einen Treiber zum Betreiben mindestens einer Lichtquelle der Leuchtvorrichtung, welcher Treiber eine Treiberplatine aufweist und an welcher mindestens ein Treiberbaustein angeordnet ist, und ferner aufweisend mindestens ein den Treiber kontaktierendes elektrisches Kontaktelement. Die Erfindung ist besonders bevorzugt einsetzbar für LED-Lampen, z.B. LED-Retrofitlampen.

LED-Retrofitlampen, welche Leuchtdioden (LEDs) aufweisen und zum Ersatz herkömmlicher Lampen dienen, weisen häufig einen Treiber auf, um ein Netzsignal (Stromsignal, Spannungssignal usw.) in ein für das Betreiben der LEDs geeignetes Signal umzuwandeln. Der Treiber weist häufig eine mit einem oder mehreren elektrischen und/oder elektronischen Treiberbausteinen bestückte Treiberplatine auf. Die Treiberplatine mag in einem elektrisch isolierenden Treibergehäuse eingesetzt sein und wird zu ihrer elektrischen Kontaktierung beispielsweise nach Einsatz in das Treibergehäuse mit Kabeln verlötet. Jedoch ist dies herstellungstechnisch vergleichsweise aufwändig.

US 2011/0028015 A1 offenbart eine Lampenanordnung mit mehreren elektrischen Kontaktelementen, die mechanisch und elektrisch mit dem Sockel verbunden sind. Die Kontaktelemente sind als Steckverbindungen ausgeführt.

Die US 2010/033972 A1 betrifft ein LED Modul.

Es ist die **Aufgabe** der vorliegenden Erfindung, die Nachteile des Standes der Technik zumindest teilweise zu überwinden und insbesondere eine Möglichkeit zur einfachen und schnellen Montage eines Treibers in einer Leuchtvorrichtung bereitzustellen, welche zudem eine zuverlässige Kontaktierung ermöglicht.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch eine Leuchtvorrichtung, aufweisend einen Treiber zum Betreiben mindestens einer Lichtquelle der Leuchtvorrichtung, welcher Treiber eine Treiberplatine aufweist, welche mindestens ein oberflächenseitiges elektrisches Kontaktfeld aufweist und an welcher mindestens ein Treiberbaustein angeordnet ist. Die Leuchtvorrichtung weist ferner mindestens ein den Treiber kontaktierendes elektrisches Kontaktelement auf. Mindestens ein elektrisches Kontaktelement weist einen Klemmkontakt auf, in welchen mindestens ein elektrisches Kontaktfeld der Treiberplatine durch eine Einsteckbewegung einsteckbar ist.

Der mindestens eine Klemmkontakt weist zwei federnde, voneinander beabstandete Kontaktlaschen auf, zwischen welche die Treiberplatine einsteckbar ist. Dies weist den Vorteil auf, dass die Treiberplatine zwischen die Kontaktlaschen einklemmbar ist und aufgrund der so ausgeübten Vorspannung der Kontaktlaschen sowohl elektrisch besonders sicher und dauerhaft kontaktierbar als auch mechanisch sicher fixierbar ist. Ein Grundbereich des Kontaktelements, von welchem die Kontaktlaschen hochgebogen sind, weist eine Klemmdurchführung auf. Ein Grundbereich des Kontaktelements, von welchem die Kontaktlaschen hochgebogen sind, weist eine Schraubdurchführung auf.

An einem den Kontaktlaschen entgegengesetzten Ende des Kontaktelements ist eine in Richtung der Kontaktlaschen hochstehende Befestigungslasche zur Befestigung an einem Treibergehäuse vorhanden. Zur Befestigung des Kontaktelements an dem Treibergehäuse ist das Kontaktelement zunächst mittels der Klemmdurchführung an einem vorspringenden Bolzen des Treibergehäuses klemmpassend aufsteckbar und dann mittels einer durch die Schraubdurchführung geführten Schraube verschraubbar.

Diese Leuchtvorrichtung weist den Vorteil auf, dass nach der Einsteckbewegung keine anderen Montageschritte zur Kontaktierung mehr notwendig sind. Dabei ist ein Kontaktelement mit Klemmkontakt einfach auszubilden, preiswert und robust. Durch das Einstecken wird zudem eine dauerhafte und zuverlässige Kontaktierung bereitgestellt, welche auch bei einer leichten Verschiebung oder Verwindung der Treiberplatine gegenüber dem elektrischen Kontaktelement bestehen bleibt. Dies ist insbesondere der Fall, falls das oberflächenseitige elektrische Kontaktfeld der Treiberplatine eine gewisse Weglänge an dem Klemmkontakt gleiten kann.

Ein solches elektrisches Kontaktelement ist insbesondere weit einfacher ausgestaltbar als beispielsweise eine Steckverbindung und sicherer als beispielsweise ein flächiger Druckkontakt.

Es ist eine Weiterbildung, dass das elektrische Kontaktelement, insbesondere dessen Klemmkontakt, zumindest oberflächlich elektrisch leitend ausgebildet ist. Das elektrische Kontaktelement besteht insbesondere aus einem elektrisch leitfähigen Material, insbesondere Aluminium oder Kupfer.

Die mindestens eine Lichtquelle umfasst insbesondere mindestens eine Halbleiterlichtquelle, insbesondere Leuchtdiode. Bei Vorliegen mehrerer Leuchtdioden können diese in der gleichen Farbe oder in verschiedenen Farben leuchten. Eine Farbe kann monochrom (z.B. rot, grün, blau usw.) oder multichrom (z.B. weiß) sein. Auch kann das von der mindestens einen Leuchtdiode abgestrahlte Licht ein infrarotes Licht (IR-LED) oder ein ultraviolettes Licht (UV-LED) sein. Mehrere Leuchtdioden können ein Mischlicht erzeugen; z.B. ein weißes Mischlicht. Die mindestens eine Leuchtdiode kann mindestens einen wellenlängenumwandelnden Leuchtstoff enthalten (Konversions-LED). Der Leuchtstoff kann alternativ oder zusätzlich entfernt von der Leuchtdiode angeordnet sein ("Remote Phosphor"). Die mindestens eine Leuchtdiode kann in Form mindestens einer einzeln gehäusten Leuchtdiode oder in Form mindestens eines LED-Chips vorliegen. Mehrere LED-Chips können auf einem gemeinsamen Substrat ("Submount") montiert sein. Die mindestens eine Leuchtdiode kann mit mindestens einer eigenen und/oder gemeinsamen Optik zur Strahlführung ausgerüstet sein, z.B. mindestens einer Fresnel-Linse, Kollimator, und so weiter. Anstelle oder zusätzlich zu anorganischen Leuchtdioden, z.B. auf Basis von InGaN oder AlInGaP, sind allgemein auch organische LEDs (OLEDs, z.B. Polymer-OLEDs) einsetzbar. Alternativ kann die mindestens eine Halbleiterlichtquelle z.B. mindestens einen Diodenlaser aufweisen.

Der Treiber kann insbesondere eine oder mehrere Treiberbausteine aufweisen, z.B. mindestens einen Elektronikbaustein. Der Treiber mag insbesondere elektrisch zwischen die mindestens eine Lichtquelle und einen elektrischen Außenanschluss der Leuchtvorrichtung (z.B. einen herkömmlichen Sockel) geschaltet sein.

Es ist eine Ausgestaltung, dass die Kontaktlaschen einander zugewandte Einführschrägen aufweisen. Dies ermöglicht ein einfaches Einstecken der Treiberplatine in den Klemmkontakt ohne Verhaken. Die Einführschrägen sind insbesondere an einem endseitigen Bereich der Kontaktlaschen angeordnet.

Es ist eine weitere Ausgestaltung, dass das mindestens eine elektrische Kontaktelement als ein Blechelement ausgestaltet ist. Ein Blechelement ist besonders preiswert und einfach formbar. Eine Ausgestaltung davon ist es, dass dessen Kontaktlaschen als hochgebogene Endbereiche ausgebildet sind. Die Kontaktlaschen können insbesondere als rechtwinklig hochgebogene Endbereiche ausgebildet sein. So wird eine einfache Herstellung mittels eines Biegeablaufs ermöglicht. Die Kontaktlaschen können beispielweise zuvor ausgestanzt worden sein. Insgesamt mag das Kontaktelement als Stanz/Biege-Bauteil hergestellt worden sein bzw. vorliegen.

Es ist noch eine weitere Ausgestaltung, dass ein geringster Abstand zwischen den beiden Kontaktlaschen geringer ist als eine Dicke der Treiberplatine. So wird eine merkliche Aufbiegung der Kontaktlaschen und damit eine feste Kontaktierung und Fixierung der Treiberplatine erreicht, ohne den Einsteckvorgang merklich zu erschweren.

Es ist eine Ausgestaltung davon, dass der geringste Abstand zwischen den beiden Kontaktlaschen mindestens 0,2 mm bis 0,4 mm geringer ist als eine Dicke der Treiberplatine. Beispielsweise mag der geringste Abstand z.B. 0,9 mm betragen, während eine Dicke der Treiberplatine (im Bereich des Kontaktfelds der Treiberplatine) z.B. 1,2 mm betragen kann.

Es ist auch eine Ausgestaltung, dass das mindestens eine oberflächenseitige elektrische Kontaktfeld in einer Einsteckrichtung zumindest einseitig, insbesondere beidseitig, seitlich mindestens einen Führungssteg aufweist. Das mindestens eine oberflächenseitige elektrische Kontaktfeld mag also insbesondere seitlich in Einführungsrichtung von mindestens einem Führungssteg begrenzt sein. Dies erleichtert eine korrekte Positionierung der Treiberplatine in Bezug auf den mindestens einen Klemmkontakt und damit auch eine sichere Kontaktierung.

Es ist außerdem eine Ausgestaltung, dass die Leuchtvorrichtung mindestens zwei elektrische Kontaktelemente aufweist, in deren Klemmkontakte die Treiberplatine durch die Einsteckbewegung einsteckbar ist, insbesondere mittig einsteckbar ist.

Es ist ferner eine Ausgestaltung, dass das mindestens eine elektrische Kontaktelement einen Teil eines die Treiberplatine aufnehmenden Treibergehäuses darstellt bzw. daran befestigt ist. Dies ermöglicht eine stabile und kompakte Bauweise.

Es ist eine Ausgestaltung davon, dass die Kontaktlaschen jeweils in einer kontaktseitig offenen Führungsschiene verlaufen, welche sich in Einsteckrichtung weiter zu der Treiberplatine hin erstrecken als die zugehörige Kontaktlasche und kontaktseitig hinter der zugehörigen Kontaktlasche zurückstehen. Dadurch wird die Einführung und Heranführung der Treiberplatine in den bzw. an den mindestens einen Klemmkontakt erleichtert. Auch wird so eine besonders stabile Bauweise bereitgestellt.

Es ist zudem eine Ausgestaltung, dass ein Grundbereich des Kontaktelements, von welchem die Kontaktlaschen hochgebogen sind, an seinem den Kontaktlaschen entgegengesetzten Ende in eine den Kontaktlaschen entgegengesetzte Richtung senkrecht umgebogen ist.

Die Leuchtvorrichtung ist grundsätzlich nicht beschränkt und mag beispielsweise ein Modul, eine Lampe, eine Leuchte oder ein Leuchtensystem sein.

Insbesondere mag die Leuchtvorrichtung eine Retrofitlampe sein, z.B. eine Glühlampen-Retrofitlampe, eine Halogenlampen-Retrofitlampe, eine Leuchtstoffröhren-Retrofitlampe usw.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden schematischen Beschreibung eines Ausführungsbeispiels, die im Zusammenhang mit den Zeichnungen näher erläutert werden. Dabei können zur Übersichtlichkeit gleiche oder gleichwirkende Elemente mit gleichen Bezugszeichen versehen sein.
- Fig.1: zeigt in Schrägansicht einen Treiber einer Leuchtvorrichtung,
- Fig.2: zeigt in dazu passender Schrägansicht ein elektrisches Kontaktelement der Leuchtvorrichtung zur Kontaktierung der Treiberplatine;
- Fig.3: zeigt als Schnittansicht in Schrägansicht einen Ausschnitt aus einem Treibergehäuse der Leuchtvorrichtung mit dem elektrischen Kontaktelement und der darin eingesetzten Treiberplatine; und
- Fig.4: zeigt als Schnittansicht in Frontaldarstellung den Ausschnitt aus dem Treibergehäuse der Leuchtvorrichtung mit dem elektrischen Kontaktelement und der darin eingesetzten Treiberplatine.

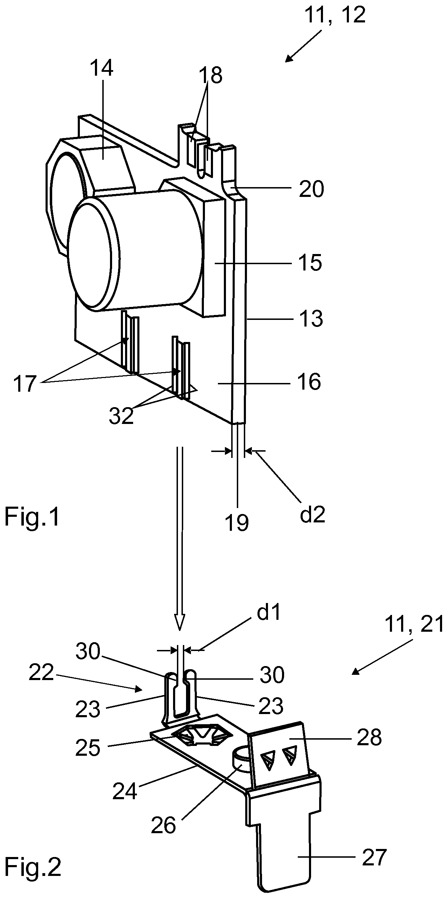

**Fig.1** zeigt in Schrägansicht einen Treiber 12 einer Leuchtvorrichtung 11. Die Leuchtvorrichtung 11 kann z.B. eine Retrofitlampe sein.

Der Treiber 12 weist eine Treiberplatine 13 auf, die mit zwei Treiberbausteinen 14, 15 bestückt ist. Der Treiber 12 dient zum Betreiben von Leuchtdioden (o.Abb.), insbesondere weißes Licht erzeugenden Leuchtdioden. Der Treiber 12 kann dazu an einen elektrischen Außenanschluss der Leuchtvorrichtung (z.B. einen Edison-Sockel oder einen Bipin-Sockel, o.Abb.) angeschlossen sein.

Zur elektrischen Kontaktierung weist die Treiberplatine 13 an einer Vorderseite 16 oberflächenseitige elektrische Kontaktfelder 17, 18 auf, nämlich ein an einen unteren Rand 19 grenzendes Paar von Kontaktfeldern 17 und ein an einen oberen Rand 20 grenzendes, dort vorstehendes Paar von Kontaktfeldern 18.

**Fig.2** zeigt in dazu passender Schrägansicht ein elektrisches Kontaktelement 21 der Leuchtvorrichtung 11 zur Kontaktierung der Kontaktfelder 17 der Treiberplatine 13. Das Kontaktelement 21 ist als ein gestanztes und gebogenes Blechteil aus Metall ausgebildet und weist an einem Endbereich einen Klemmkontakt 22 auf. Der Klemmkontakt wird durch Ausstanzen und senkrechtes Hochbiegen zweier federnder, voneinander beabstandeten Kontaktlaschen 23 gebildet.

Ein Grundbereich 24 des Kontaktelements 21, von welchem die Kontaktlaschen 23 hochgebogen sind, weist eine Klemmdurchführung 25 und eine Schraubdurchführung 26 auf und ist an seinem den Kontaktlaschen 23 entgegengesetzten Ende in eine den Kontaktlaschen 23 entgegengesetzte Richtung senkrecht umgebogen. Dadurch wird dort eine Kontaktfahne 27 gebildet, beispielsweise zum Aufstecken von diesen umgebenden elektrischen Aufsetzkontakten (o.Abb.), welche mit dem Aussenanschluss (o.Abb.) verbunden sind.

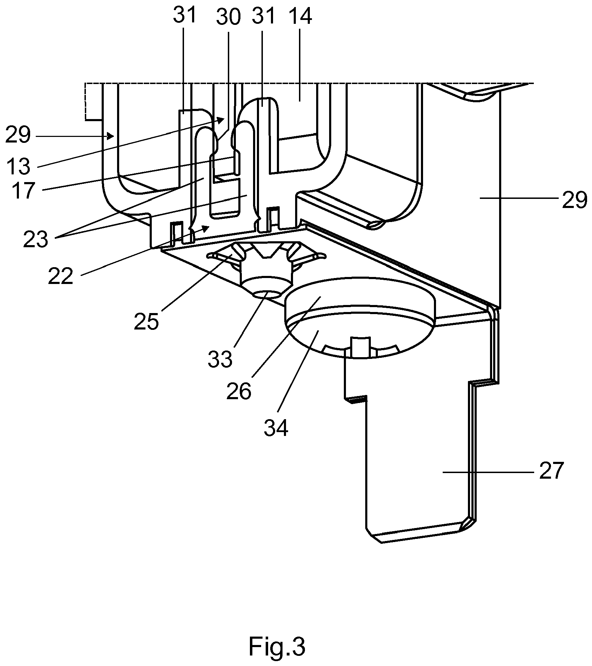

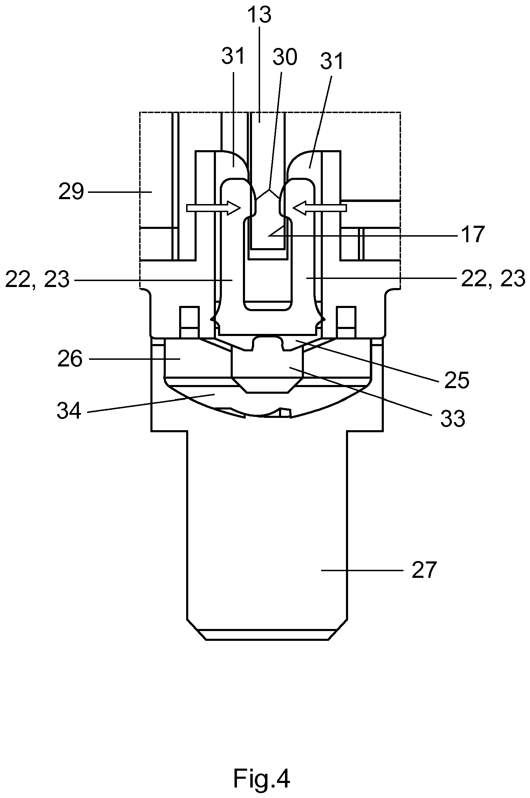

Zusätzlich ist an dem den Kontaktlaschen 23 entgegengesetzten Ende eine in Richtung der Kontaktlaschen 23 hochstehende Befestigungslasche 28 zur Befestigung an einem Treibergehäuse 29 (siehe Fig.3 oder Fig.4) vorhanden.

Zur Montage des Treibers 12 wird dieser mit einer einfachen Einsteckbewegung in die Kontaktlaschen 23 eingesteckt. Dadurch gleiten die Kontaktfelder 17 eine gewisse Weglänge über eine ihnen jeweils zugewandte Kontaktlasche 23.
Der Treiber 12 ist durch diese Einsteckbewegung mechanisch zwischen den Kontaktlaschen 23 festgeklemmt und mit diesen elektrisch verbunden, wie auch in **Fig.3** und **Fig.4** dargestellt. Da das zugehörige Kontaktelement 21 an dem Treibergehäuse 29 befestigt ist, wird so durch eine einfache Steckbewegung auch eine feste und sichere Unterbringung des Treibers 12 in dem Treibergehäuse 29 erreicht. Nach der Einsteckbewegung sind zumindest an der Seite der Kontaktfelder 17 keine weiteren Montageschritte zur Kontaktierung mehr notwendig.

Zur Vereinfachung des Einsteckvorgangs, z.B. um ein Verhaken zu verhindern, weisen die Kontaktlaschen 23 im Bereich ihrer endständigen, freien Enden an ihren zugewandten Seiten Einführschrägen 30 auf.

Zur weiteren Vereinfachung des Einsteckvorgangs verlaufen die Kontaktlaschen 23 jeweils in einer kontaktseitig offenen Führungsschiene 31 des Treibergehäuses 29, welche sich in Einsteckrichtung weiter zu der Treiberplatine 13 hin erstrecken als die zugehörige Kontaktlasche 23 und kontaktseitig hinter der zugehörigen Kontaktlasche 23 zurückstehen.

Zur besonders festen Kontaktierung und Fixierung der Treiberplatine 13 ist ein Abstand d1 (z.B. 0,9 mm) zwischen den beiden Kontaktlaschen 23, nämlich zwischen den Einführschrägen 30, geringer als eine Dicke d2 (z.B. 1,2 mm) der Treiberplatine 13 im Bereich der Kontaktfelder 17. So wird eine merkliche Aufbiegung der Kontaktlaschen 23 und damit eine feste Kontaktierung und Fixierung der Treiberplatine 13 erreicht, ohne den Einsteckvorgang merklich zu erschweren, wie z.B. in Fig.4 durch die Pfeile angedeutet.

Zur genauen Positionierung der Treiberplatine 13 in Bezug auf die Kontaktelemente 21 sind die Kontaktfelder in der Einsteckrichtung (in der gezeigten Darstellung senkrecht) beidseitig von jeweils einem Führungssteg 32 begrenzt.

Obwohl nicht gezeigt, weist das Treibergehäuse 29 der Leuchtvorrichtung 11 mindestens zwei elektrische Kontaktelemente 21 auf, in deren Klemmkontakten 22 die Treiberplatine 13 an ihren Kontaktfeldern 17 durch die Einsteckbewegung einsteckbar ist, insbesondere mittig einsteckbar ist.

Zur Befestigung des Kontaktelements 21 an dem Treibergehäuse 29 kann das Kontaktelement 21 zunächst mittels der Klemmdurchführung 25 an einem vorspringenden Bolzen 33 des Treibergehäuses 29 klemmpassend aufgesteckt werden und dann einfach mittels einer durch die Schraubdurchführung 26 geführten Schraube 34 fest verschraubt werden.

Obwohl die Erfindung im Detail durch das gezeigte Ausführungsbeispiel näher illustriert und beschrieben wurde, so ist die Erfindung nicht darauf eingeschränkt und andere Variationen können vom Fachmann hieraus abgeleitet werden, ohne den Schutzumfang der Erfindung zu verlassen.

## Patentansprüche

1. Leuchtvorrichtung (11), aufweisend
- einen Treiber (12) zum Betreiben mindestens einer Lichtquelle der Leuchtvorrichtung(11),
- welcher Treiber (12) eine Treiberplatine (13) aufweist, welche mindestens ein oberflächenseitiges elektrisches Kontaktfeld (17; 18) aufweist und an welcher mindestens ein Treiberbaustein (14; 15) angeordnet ist,
- und ferner aufweisend mindestens ein den Treiber (12) kontaktierendes elektrisches Kontaktelement (21),
wobei
- mindestens ein elektrisches Kontaktelement (21) einen Klemmkontakt (22) aufweist, in welchen mindestens ein elektrisches Kontaktfeld (17) der Treiberplatine (13) durch eine Einsteckbewegung einsteckbar ist, und
wobei der mindestens eine Klemmkontakt (22) zwei federnde, voneinander beabstandete Kontaktlaschen (23) aufweist, zwischen welche die Treiberplatine (13) einsteckbar ist, **dadurch gekennzeichnet, dass** ein Grundbereich (24) des Kontaktelements (21), von welchem die Kontaktlaschen (23) hochgebogen sind, eine Klemmdurchführung (25) aufweist, wobei ein Grundbereich (24) des Kontaktelements (21), von welchem die Kontaktlaschen (23) hochgebogen sind, eine Schraubdurchführung (26) aufweist, und wobei an einem den Kontaktlaschen (23) entgegengesetzten Ende des Kontaktelements (21) eine in Richtung der Kontaktlaschen (23) hochstehende Befestigungslasche (28) zur Befestigung an einem Treibergehäuse (29) vorhanden ist, und wobei zur Befestigung des Kontaktelements (21) an dem Treibergehäuse (29) das Kontaktelement (21) zunächst mittels der Klemmdurchführung (25) an einem vorspringenden Bolzen (33) des Treibergehäuses (29) klemmpassend aufsteckbar ist und dann mittels einer durch die Schraubdurchführung (26) geführten Schraube (34) verschraubbar ist.

2. Leuchtvorrichtung (11) nach Anspruch 1, wobei das Kontaktelement (21) ein Stanz/Biege-Bauteil ist.

3. Leuchtvorrichtung (11) nach einem der Ansprüche 1 oder 2, wobei das mindestens eine elektrische Kontaktelement (21) als ein Blechelement ausgestaltet ist, dessen Kontaktlaschen (23) als hochgebogene Endbereiche ausgebildet sind.

4. Leuchtvorrichtung (11) nach einem der vorhergehenden Ansprüche, wobei der Grundbereich (24) des Kontaktelements (21), von welchem die Kontaktlaschen (23) hochgebogen sind, an seinem den Kontaktlaschen (23) entgegengesetzten Ende in eine den Kontaktlaschen (23) entgegengesetzte Richtung senkrecht umgebogen ist.

5. Leuchtvorrichtung (11) nach einem der vorhergehenden Ansprüche, wobei das mindestens eine oberflächenseitige elektrische Kontaktfeld (17) in einer Einsteckrichtung zumindest einseitig, insbesondere beidseitig, seitlich mindestens einen Führungssteg (32) aufweist.

6. Leuchtvorrichtung (11) nach einem der vorhergehenden Ansprüche, wobei die Leuchtvorrichtung (11) mindestens zwei elektrische Kontaktelemente (21) aufweist, in deren Klemmkontakte (22) die Treiberplatine (13) durch die Einsteckbewegung einsteckbar ist, insbesondere mittig einsteckbar ist.

7. Leuchtvorrichtung (11) nach einem der vorhergehenden Ansprüche, wobei das mindestens eine elektrische Kontaktelement (21) einen Teil des die Treiberplatine (13) aufnehmenden Treibergehäuses (29) darstellt.

8. Leuchtvorrichtung (11) nach Anspruch 7, wobei die Kontaktlaschen (23) jeweils in einer kontaktseitig offenen Führungsschiene (31) des Treibergehäuses (29) verlaufen, welche sich in Einsteckrichtung weiter zu der Treiberplatine (13) hin erstrecken als die zugehörige Kontaktlasche (23) und kontaktseitig hinter der zugehörigen Kontaktlasche (23) zurückstehen.

9. Leuchtvorrichtung (11) nach einem der vorhergehenden Ansprüche, wobei die mindestens eine Lichtquelle mindestens eine Halbleiterlichtquelle, insbesondere Leuchtdiode, umfasst.

10. Leuchtvorrichtung (11) nach einem der vorhergehenden Ansprüche, wobei die Leuchtvorrichtung (11) eine Retrofitlampe ist.

## Claims

1. Lighting apparatus (11), having
- a driver (12) for operating at least one light source of said lighting apparatus (11),
- said driver (12) having a driver circuit board (13) which has at least one surface-side electrical contact field (17; 18) and on which at least one driver module (14; 15) is arranged,
and further having at least one electrical contact element (21) contacting said driver (12),
wherein
- at least one electrical contact element (21) has a clip contact (22) into which at least one electrical contact field (17) of the driver circuit board (13) can be inserted by means of an insertion movement, and
wherein the at least one clip contact (22) has two springy contact lugs (23), spaced apart from each other, between which the driver circuit board (13) can be inserted,
**characterized in that**
a base region (24) of the contact element (21), from which the contact lugs (23) are bent upwards, has a clamping lead-through (25), wherein a base region (24) of the contact element (21), from which the contact lugs (23) are bent upwards, has a screw lead-through (26), and wherein a fastening lug (28), protruding in the direction of the contact lugs (23), for fastening to a driver housing (29) is present at one end of the contact element (21) opposing the contact lugs (23),
and wherein
for fastening the contact element (21) to the driver housing (29), the contact element (21) can initially be attachable by means of a clamping lead-through (25) in a clamp fitting manner to a projecting stud (33) of the driver housing (29), and can then be screwed by means of a screw (34) guided through the screw lead-through (26).

2. Lighting apparatus (11) according to claim 1, wherein the contact element (21) is a stamped/bent component.

3. Lighting apparatus (11) according to one of claims 1 or 2, wherein the at least one electrical contact element (21) is designed as a sheet metal element, the contact lugs (23) of which are formed as bent up end regions.

4. Lighting apparatus (11) according to one of the preceding claims, wherein the base region (24) of the contact element (21), from which the contact lugs (23) are bent upwards, is bent up vertically at its end opposing the contact lugs (23) in a direction opposing said contact lugs (23).

5. Lighting apparatus (11) according to one of the preceding claims, wherein the at least one surface-side electrical contact field (17) has laterally at least one guide bar (32) on at least one side, in particular on both sides, in an insertion direction.

6. Lighting apparatus (11) according to one of the preceding claims, wherein the lighting apparatus (11) has at least two electrical contact elements (21) into whose clip contacts (22) the driver circuit board (13) can be inserted, in particular can be inserted centrally, by means of the insertion movement.

7. Lighting apparatus (11) according to one of the preceding claims, wherein the at least one electrical contact element (21) represents a portion of the driver housing (29) accommodating the circuit board (13).

8. Lighting apparatus (11) according to claim 7, wherein the contact lugs (23) each extend in a guide rail (31) of the driver housing (29), said lugs being open on the contact side, said guide rail extending in the insertion direction further towards the driver circuit board (13) than the associated contact lug (23) and standing back behind the associated contact lug (23) on the contact side.

9. Lighting apparatus (11) according to one of the preceding claims, wherein the at least one light source comprises at least one semiconductor light source, in particular light-emitting diode.

10. Lighting apparatus (11) according to one of the preceding claims, wherein said lighting apparatus (11) is a retrofit lamp.

## Revendications

1. Dispositif d'éclairage (11), disposant
- d'un pilote (12) destiné à faire fonctionner au moins une source de lumière du dispositif d'éclairage (11),
- le pilote (12) comportant une platine d'excitateur (13), laquelle comporte au moins un champ de contact électrique (17 ; 18) à la surface et sur laquelle est agencé au moins un module de pilote (14 ; 15),
et comportant par ailleurs au moins un élément de contact électrique (21) en contact avec le pilote (12),
dans lequel
- au moins un élément de contact électrique (21) comporte un contact de serrage (22), dans lequel au moins un champ de contact électrique (17) de la platine d'excitateur (13) du pilote peut être inséré par l'intermédiaire d'un mouvement d'insertion, et
dans lequel le au moins un contacts de serrage (22) comportent deux languettes de contact (23) élastiques espacées l'une par rapport à l'autre, entre lesquelles il est possible d'insérer la platine d'excitateur (13) du pilote,
**caractérisée en ce qu'**une surface de base (24) de l'élément de contact (21), par rapport à laquelle les languettes de contact (23) sont courbées vers le haut, comporte une traversée de serrage (25) ; une surface de base (24) de l'élément de contact (21), par rapport à laquelle les languettes de contact (23) sont courbées vers le haut, comportant une traversée pour vissage (26) ; et une languette de fixation (28) élevée en direction des languettes de contact (23) est présente pour assurer la fixation à un boîtier de pilote (29) sur une extrémité de l'élément de contact (21) opposée aux languettes de contact (23),
et dans laquelle
l'élément de contact (21) peut d'abord être inséré par une liaison de serrage dans un boulon (33) en saillie du boîtier du pilote (29) en passant par la traversée de serrage (25), puis vissé à l'aide d'une vis (34) passant par la traversée pour vissage, afin de fixer l'élément de contact (21) sur le boîtier du pilote (29).

2. Dispositif d'éclairage (11) selon la revendication 1, dans lequel l'élément de contact (21) est un composant à perforation/flexion.

3. Dispositif d'éclairage (11) selon l'une des revendications 1 ou 2, dans lequel le au moins un élément de contact électrique (21) sont conçus sous forme d'élément en tôle, dont les languettes de contact (23) forment des surfaces d'extrémité courbée vers le haut.

4. Dispositif d'éclairage (11) selon l'une des revendications précédentes, dans lequel la surface de base (24) des éléments de contact (21), depuis laquelle les languettes de contact (23) sont courbées vers le haut, est pliée perpendiculairement dans une direction opposée aux languettes de contact (23) au niveau de son extrémité opposée aux languettes de contact (23).

5. Dispositif d'éclairage (11) selon l'une des revendications précédentes, dans lequel le au moins un champ de contact électrique (17) de surface comportent au moins une nervure de guidage (32) latérale dans une direction d'insertion, au moins d'un côté, et en particulier des deux côtés.

6. Dispositif d'éclairage (11) selon l'une des revendications précédentes, dans lequel le dispositif d'éclairage (11) comporte au moins deux éléments de contact électrique (21), dans les contacts de serrage (22) desquels la platine d'excitateur (13) du pilote puisse être insérée sous l'effet du mouvement d'insertion, et puisse en particulier être insérée dans une position médiane.

7. Dispositif d'éclairage (11) selon l'une des revendications précédentes, dans lequel le au moins un élément de contact électrique (21) constituent une partie du boîtier du pilote (29) hébergeant la platine d'excitateur (13) du pilote.

8. Dispositif d'éclairage (11) selon la revendication 7, dans lequel les languettes de contact (23) cheminent respectivement dans un rail de guidage (31) du boîtier du pilote (29) ouvert du côté du contact, s'étendant plus loin vers la platine d'excitateur (13) du pilote dans la direction d'insertion que les languettes de contact (23) correspondantes et se trouvent en retrait par rapport aux languettes de contact (23) correspondantes dans la direction du contact.

9. Dispositif d'éclairage (11) selon l'une des revendications précédentes, dans lequel le au moins une source de lumière comprennent au moins une source de lumière semiconductrice, et en particulier une diode électroluminescente.

10. Dispositif d'éclairage (11) selon l'une des revendications précédentes, dans lequel le dispositif d'éclairage (11) est une lampe Retrofit.
